# EUROPEAN PATENT APPLICATION

(11) **EP 3 441 502 A1**
(43) Date of publication of application: **13.02.2019**
(21) Application number: 17185520.8
(22) Date of filing: 09.08.2017
(51) Int. Cl.: C23C 14/50, H01L 21/68, C23C 14/54

(54) **SUBSTRATE HOLDER FOR PHYSICAL VAPOUR DEPOSITION AND METHOD OF OPERATION**

(71) Applicant: Vestel Elektronik Sanayi ve Ticaret A.S., 45030 Manisa (TR)
(72) Inventor: KUYUCU,, Ömer Gökçe, 45030 Manisa (TR)
(74) Representative: Flint, Adam

(57) **Abstract**

A substrate holder (30) for holding a substrate (34) during physical vapour deposition of a material on the substrate (34) has a body (31) which is arranged to be rotatable during physical vapour deposition. The body has a mount (33) to which a substrate (34) may be mounted in use during physical vapour deposition. The mount (33) is arranged such that as the body (31) rotates in use, the substrate (34) is thrown outwardly by centrifugal force so as to change the orientation of the substrate (34) relative to the body (31).

## Description

### Technical Field

The present disclosure relates to a substrate holder for holding a substrate during physical vapour deposition of a material on the substrate and a method of operating a physical vapour deposition apparatus.

### Background

Physical vapour deposition (PVD) is a term used to describe a number of vacuum deposition methods which can be used to produce thin films and coatings. In PVD, the material to be coated on a substrate goes from a condensed phase to a vapour phase and then back to a thin film condensed phase. The most common PVD processes are sputtering and evaporation. PVD is commonly used in the manufacture of items that require thin films for mechanical, optical, chemical and/or electronic functions.

In physical vapour deposition, the substrate, which is to be coated, is often mounted on an apparatus that rotates the substrate during the deposition process, to try to ensure that a more even or uniform coating of the material on the substrate is achieved. The substrate may be mounted so as to rotate about a single axis or to rotate about one axis which rotates about a second axis in a so-called satellite arrangement. However, either way, it can still be difficult to ensure that all parts of the substrate are evenly coated, especially as some parts of the substrate may be hidden or shielded from the vapour by other components, including other substrates that are mounted on the apparatus during the deposition process.

### Summary

According to a first aspect disclosed herein, there is provided a substrate holder for holding a substrate during physical vapour deposition of a material on the substrate, the substrate holder comprising:
a body which is arranged to be rotatable in use during physical vapour deposition;
the body having a mount to which a substrate may be mounted in use during physical vapour deposition;
the mount being constructed and arranged such that as the body rotates in use, a substrate mounted on the mount is thrown outwardly by centrifugal force so as to change the orientation of the substrate relative to the body.

In an example, the mount comprises a first mount portion which is fixed to the body and a second mount portion to which a substrate may be mounted in use during physical vapour deposition, the first and second mount portions being pivotally connected to each other to allow a substrate mounted on the mount to be thrown outwardly by centrifugal force as the body rotates in use.

There may be additional intermediate mount portions which are pivotally connected to each other.

In an example, the mount is flexible.

In an example, the substrate holder comprises a biasing member connected to the mount to support the weight of a substrate mounted on the mount.

In an example, the substrate holder comprises a biasing member connected to the mount to control the throwing outward of a substrate mounted on the mount as the body rotates in use.

In an example, the substrate holder is a rotatable satellite substrate holder for mounting to a rotatable turntable of a physical vapour deposition apparatus.

There may also be provided a physical vapour deposition apparatus for holding a substrate during physical vapour deposition of a material on the substrate, the apparatus comprising:
a turntable which is rotatable about a first axis of rotation;
one or more substrate holders as described above, wherein the or each substrate holder is mounted on the turntable to be rotatable about a second axis of rotation which is not coincident with the first axis of rotation.

In an example, the apparatus comprises a motor for driving rotation of the turntable.

In an example, the apparatus comprises a gear arrangement drivingly connecting the motor to the turntable and drivingly connecting the motor to the or each substrate holder.

The gear arrangement may provide for different gear ratios for the respective drives to the turntable and the or each substrate holder so that the turntable and the or each substrate holder rotate at different rotational speeds. The gear arrangement may be arranged to allow different gear ratios to be selected to allow different rotational speeds to be selected for one or both of the turntable and the or each substrate holder.

According to a second aspect disclosed herein, there is provided a method of operating a physical vapour deposition apparatus for depositing a material on a substrate, the physical vapour deposition apparatus comprising a substrate holder comprising a rotatable body, the body having a mount to which a substrate is mounted, the method comprising
rotating the body at a first rotational speed; and
rotating the body at a second rotational speed which is greater than the first rotational speed to cause the substrate to be thrown outwardly by centrifugal force so as to change the orientation of the substrate relative to the body.

The order of the steps may be reversed. That is, the body may be rotated first at the second (higher) rotational speed and then rotated at the first (lower) rotational speed.

In an example, the mount comprises a first mount portion which is fixed to the body and a second mount portion to which a substrate may be mounted in use during physical vapour deposition, the first and second mount portions being pivotally connected to each other to allow a substrate mounted on the mount to be thrown outwardly by centrifugal force as the body rotates in use.

In an example, the substrate holder is a rotatable satellite substrate holder for mounting to a rotatable turntable of a physical vapour deposition apparatus.

### Brief Description of the Drawings

To assist understanding of the present disclosure and to show how embodiments may be put into effect, reference is made by way of example to the accompanying drawings in which:
Figure 1 shows schematically a plan view of a prior art physical vapour deposition apparatus;
Figure 2 shows schematically an elevation of a prior art satellite substrate holder; and
Figures 3A and 3B show schematically elevations of an example of a substrate holder according to embodiments described herein.

### Detailed Description

As mentioned, in physical vapour deposition (PVD), the substrate, which is to be coated, is often mounted on an apparatus that rotates the substrate during the deposition process, to try to ensure that an even or uniform coating of the material on the substrate is achieved. The thickness of the coating is typically related to the rotational speed. The substrate may be mounted so as to rotate about a single axis or to rotate about one axis which rotates about a second axis in a so-called satellite arrangement. However, either way, it can still be difficult to ensure that all parts of the substrate are evenly coated, especially as some parts of the substrate may be hidden or shielded from the vapour by other components, including other substrates that are mounted on the apparatus during the deposition process.

For completeness, it is mentioned here that the current description is typically given in terms of trying to ensure that an even or uniform coating of the material on the substrate is achieved. For simplicity and brevity, the specific examples given here will be described in such terms. However, it will be understood that there may be instances when a (possibly specific) non-uniform coating is desired, and rotation of the substrate(s) may be controlled at least in part to help achieve that. The apparatus described herein is equally relevant and useful in such cases.

In a PVD process that uses sputtering, one or more substrates to be coated are supported by an apparatus in a chamber having a high vacuum in order to keep unwanted film contamination at a minimum. The process chamber is typically evacuated by a pump to a residual gas pressure usually in the range of 10⁻⁶ to 10⁻⁷ mbar (where one bar = 10⁵ Pa) prior to the deposition process. The thickness of the coating film may be in the range of for example several nanometres to several microns.

A negative potential (usually of around -300V or so) is applied to a cathode structure, which establishes an electric field. Electrons from the cathode collide with the argon or other chamber gas atoms, creating ions and exciting a glow discharge. Accelerated by the cathode's negative potential, the argon ions travel parallel to the electric field lines and impact a target, composed of the coating material, which is carried on the cathode structure. The kinetic energy of these ions is sufficiently high to dislodge some target surface atoms, which can condense on the substrate to form the film.

The sputter process has almost no restrictions as to the target materials that can be used, which include for example pure metals for which a DC (direct current) power supply may be used to semiconductors and insulator for which a radio frequency or pulsed DC power supply may be used. The gas in the chamber is typically inert, and is often argon for example, though a reactive discharge may be achieved using a mixture of inert and reactive gasses in the chamber. The target may be a single element target or a multi-element target.

One technique, commonly referred to as magnetron sputtering, uses magnetic fields to enhance the ion bombardment of the target (i.e. the source of the coating material, which is to be coated on the substrate). A relatively strong magnetic field is induced in the vicinity of the target face, with the magnetic field lines being oriented generally perpendicular to those of the electric field. As the argon ions strike the target, neutral atoms, molecules and secondary electrons are emitted from the target. The ejected atoms move toward the substrate where they condense to form a thin film of the coating material. The secondary electrons collide with the inert gas in the chamber and help to maintain the plasma. The secondary electrons emitted from the target are influenced by the magnetic field so that their paths of motion become curved. Thus, the magnetic field traps the electrons near the target. This results in electron-argon collisions close to the target face, thereby maximising the argon ion flux bombarding the target. This also means that the plasma of argon ions and electrons can be sustained at a lower pressure. The sputtered atoms are neutrally charged and so are unaffected by the magnetic trap. The plasma in the conventional magnetron sputtering method is concentrated above the target and might cause ions to bombard and affect the corresponding film on the substrate. This is eliminated in the unbalanced magnetron sputtering method, where the magnetic field is arranged so as to spread the plasma. This helps to maintain a low ion concentration near the substrate.

In known PVD apparatus, whether or not magnetron sputtering is used, it is known to rotate the substrates which are to be coated during the coating process. This helps to ensure that the coating is applied more evenly over all surfaces of the substrate. Moreover, rotation of the substrate helps to move a substrate out of a "shadow" that may be caused by the presence of other substrates or other components in the chamber.

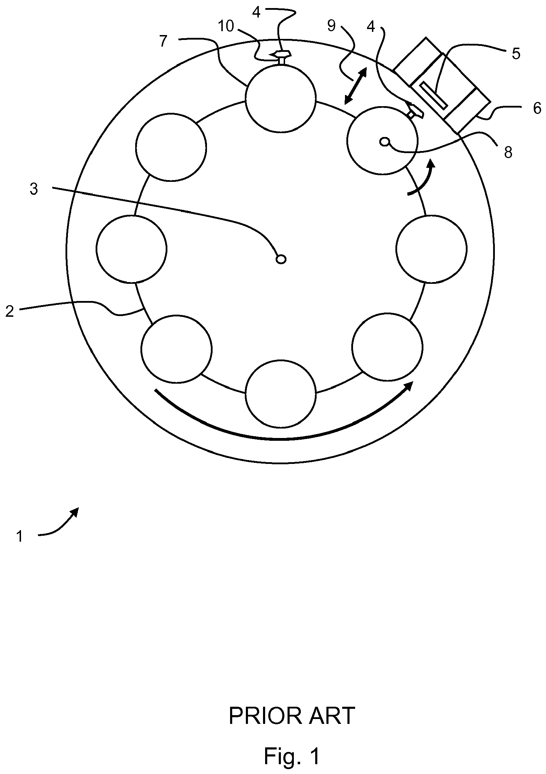

This can be seen by referring to the example of a prior art PVD apparatus 1 which is shown schematically in plan view in Figure 1. The PVD apparatus 1 has a main turntable 2 which is rotatable about an axis of rotation 3. One or more substrates 4 to be coated are mounted on the turntable 2. A target 5 of the material to be coated onto the substrates 4 is arranged to be bombarded by the ions of the argon or other gas which fills the chamber in which the apparatus 1 is contained and is arranged such that atoms of the target that are dislodged by the bombardment move into the chamber and coat the substrates 4. In this example, a magnetron 6 is located in the vicinity of the target 5 to generate a magnetic field which maximises the argon or other ion flux bombarding the target 5 as described above.

Because of the mounting of the target 5 which, inevitably, is to the side of the apparatus 1, rotation of the turntable 2 about the axis of rotation 3 brings the substrates 4 in the vicinity of the target 5 in turn, helping to ensure that each substrate 4 becomes coated evenly.

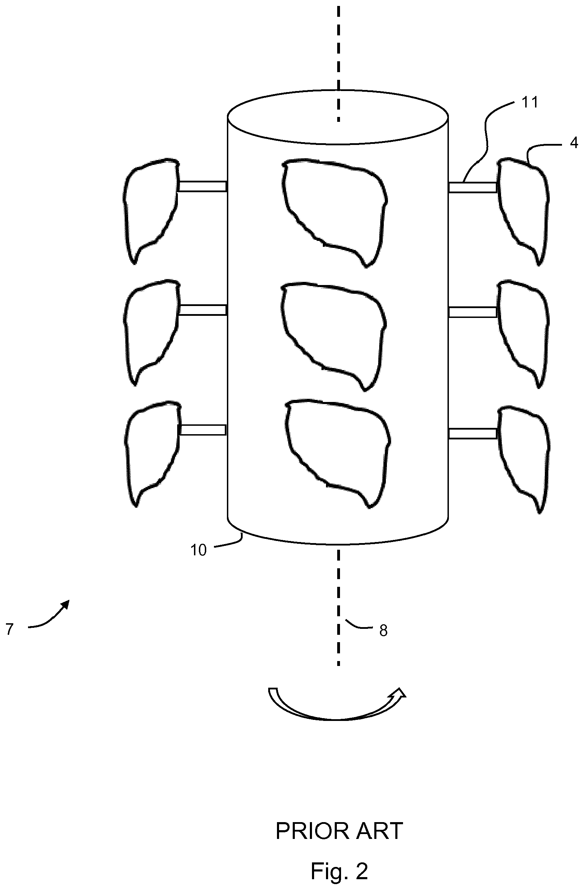

To improve further the uniformity of the coating on the substrates 4, the substrates 4 are often mounted on rotatable "satellite" substrate holders 7 (often referred to more simply just as "satellites") which themselves are mounted for rotation on the turntable 2. An example of a rotatable satellite substrate holder 7 is shown schematically in elevation in Figure 2. The satellite substrate holders 7 each have an axis of rotation 8 which is not coincident with the axis of rotation 3 of the main turntable 2. The substrates 4 are mounted on the satellite substrate holders 7 to be off-axis and so are caused to rotate around the axis of rotation 8 of the satellite substrate holders 7 as the satellite substrate holders 7 rotate around their axis of rotation 8. This helps to ensure that all parts of the substrate 4 are coated, even those that are at the "rear" of the substrate 4, i.e. facing towards the satellite substrate holder 7 on which the substrate 4 is mounted.

In Figure 1, for clarity only a single substrate 4 is shown fixed to each of two satellite substrate holders 7. In practice, as shown more clearly in Figure 2, typically several substrates 4 are fixed around each satellite substrate holder 7 during deposition. There may be for example a number of "layers" or levels of substrates 4 mounted on each substrate holder 7 which are distributed along the length of the substrate holder 7 and each of which carries plural substrates 4.

Accordingly, as the turntable 2 is rotated about its axis of rotation 3, the satellite substrate holders 7 are brought in turn into the vicinity of the target 5. Moreover, as the individual satellite substrate holders 7 are rotated about their individual axes of rotation 8, each substrate 4 on the satellite substrate holder 7 is brought in turn into the region where coating of the target material on the substrates 4 can occur. This region in this example is close to the target 5 and typically lies broadly in the annular region 9 between the location of the target 5 and the rotational path of the satellite substrate holders 7 as they are rotated about the axis of rotation 3 of the turntable 2.

A drive mechanism (not shown) drives the rotation of the turntable 2 and the satellite substrate holders 7. The drive mechanism may use for example a single motor which is connected to the turntable 2 and the satellite substrate holders 7 using different respective gear ratios to achieve a desired relative rate of rotation between the turntable 2 and the satellite substrate holders 7. The drive mechanism may alternatively use separate motors and gear mechanisms for rotating the turntable 2 and the satellite substrate holders 7. The rates of rotation may be varied in use.

However, even though the substrates 4 are caused to rotate about at least one axis of rotation (the axis of rotation 3 of the turntable), and even though in the satellite arrangement the substrates 4 are caused to rotate a second axis of rotation (the axis of rotation 8 of the individual substrate holder 7), it can still occur that some parts of the substrates 4 are not coated uniformly as desired. This may be because for example one substrate 4 partly blocks or shadows another substrate 4. Another reason is that the three dimensional shape of the substrate 4 may be complex. In any event, it can be difficult to ensure that all surfaces of the substrate 4 are coated uniformly with this type of arrangement.

Accordingly, there is provided herein a substrate holder for holding a substrate during physical vapour deposition of a material on the substrate. The substrate holder has a body which is arranged to be rotatable in use during physical vapour deposition. The body has a mount to which a substrate may be mounted in use during physical vapour deposition. The mount is constructed and arranged such that as the body rotates in use, a substrate mounted on the mount is thrown outwardly by centrifugal force so as to change the orientation of the substrate relative to the body. This helps to ensure that a more uniform coating is applied to the substrate. The movement of the substrate relative to the body helps to ensure that all parts of the substrate are presented to the coating vapour and helps to expose parts of the substrate that otherwise might be blocked or occluded. The substrate holder may be used in PVD processes that do not use magnetrons and PVD processes that do use magnetrons to enhance the ion bombardment of the target.

In some examples, the substrate holder may be arranged in effect so that the body forms a main turntable of a PVD apparatus, and therefore the substrate holder only rotates about a single axis of rotation in use. In other examples, the substrate holder may be arranged as a satellite substrate holder, which rotates in use about its own axis of rotation and which is rotated as a whole about an axis of rotation of a main turntable of a PVD apparatus, similarly to the prior art shown schematically in Figure 1.

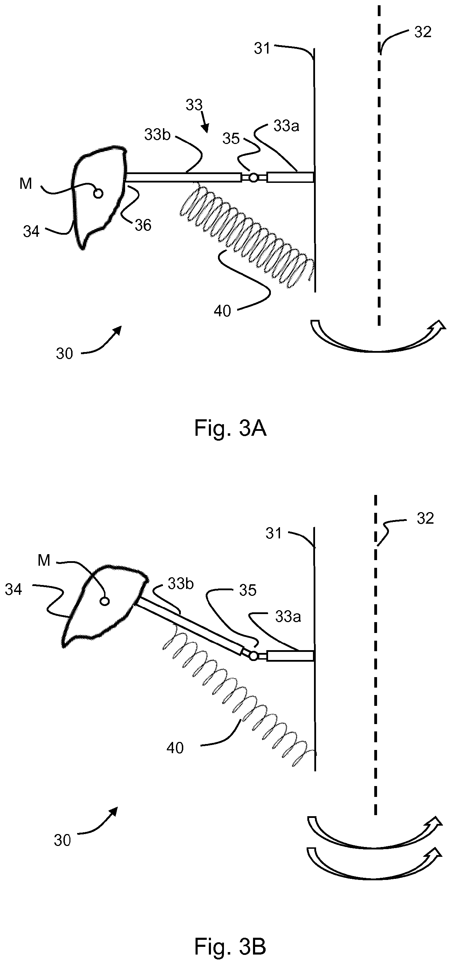

Referring to Figures 3A and 3B, a portion of an example of a substrate holder 30 as described herein is schematically shown. The substrate holder 30 of this example is a satellite substrate holder such that the substrate holder 30 rotates about (at least) two (usually parallel) axes of rotation in use, similarly to the prior art shown schematically in Figure 1 and discussed above. In other examples, the substrate holder 30 may be part of a main turntable of a PVD apparatus such that the substrate holder 30 only rotates about a single axis of rotation in use. The detailed structure and arrangement of the substrate holder 30 may be different for different applications, and may for example be tailored according to the specific properties of the substrate to be coated (including its size and shape) and the nature of the coating to be applied.

The substrate holder 30 has a body 31 which is rotatable about an axis of rotation 32. In the case that the substrate holder 30 is a satellite substrate holder, the body 31 of this example corresponds to the body 10 of the prior art example shown in Figures 1 and 2. In the case that the substrate holder 30 is part of a main turntable of a PVD apparatus, the body 31 of this example corresponds to the main turntable 2 of the prior art example shown in Figure 1.

The substrate holder 30 has a mount 33 to which a substrate 34 to be coated may be mounted in use. The mount 33 is fixed to and typically extends radially outwardly of the body 31. There may be plural such mounts 33, each for carrying a respective substrate 34.

The substrate holder 30 is constructed and arranged such that as the body 31 rotates in use, a substrate 34 mounted on the mount 33 is thrown outwardly by centrifugal force so as to change the orientation of the substrate 34 relative to the body 31. A number of ways of achieving this are possible, some examples of which will be described further below. But in any event, this effect can be seen by comparing Figures 3A and 3B. In the situation in Figure 3A, the substrate holder 30 is being rotated at a first rotational speed about the axis of rotation 32, which is indicated by a single broad curved arrow. Then, in the situation in Figure 3B, the substrate holder 30 is being rotated at a second rotational speed about the axis of rotation 32 which is greater than the first rotational speed, which is indicated by two broad curved arrows. Whilst the detailed effect of this may be different for different specific examples as will be discussed further below, overall the amount or degree that the mount 33 is thrown outwardly by centrifugal force will be different depending on the rotational speed. This means that the orientation of the substrate 34 relative to the body 31 will be different, depending on the rotational speed. This means in turn that different portions of the substrate 34 may be presented to the target (which is the source of the atoms used for the PVD coating) or, more generally, to the region where sputtered coating atoms are present, depending on the rotational speed. This can help ensure that no portions of the substrate 34 are blocked or occluded by other substrates 34 or other components in the PVD chamber, or at least reduces that amount of the substrate 34 that is blocked or occluded by other substrates 34 or other components in the PVD chamber. This can also reduce the processing time and reduce consumption of the target coating material, as more uniform coatings can be achieved more quickly and efficiently.

Various different arrangements for enabling a substrate 34 mounted on the mount 33 to be thrown outwardly by centrifugal force are possible. A relevant factor for this is that in operation, the PVD chamber may have a very low residual gas pressure, such as in the range of 10⁻⁶ to 10⁻⁷ mbar (where one bar = 10⁵ Pa). This means that it may be difficult to provide for example specific electrical or pneumatic equipment to rotate the substrate holder 30 and allow the rotational speed of the substrate holder 30 to be varied using for example electrical motors or pneumatic pistons or the like.

In one example, the mount 33 for the substrate 34 may be a flexible rod or the like. This contrasts with the rigid mounts 11 that are used in prior art PVD apparatus 1, as indicated in Figures 1 and 2. As the rotational speed of the substrate holder 30 is increased, the flexible mount 33 can flex along its length, allowing centrifugal force to throw the substrate 34 outwardly, thereby changing the orientation of the substrate 34 relative to the body 31. A flexible mount 33 may be formed of plastic, for example polyamide or polypropylene. An advantage of plastic is that it may be less liable to be coated by the material which is to be coated in the substrate 34 (particularly if the material is a metal, such as chromium, etc.). As an alternative, a flexible mount 33 may be formed of a metal, such as a steel. An advantage of a metal, such as steel, is that it may be easier to clean to remove coated material after the deposition on the substrate 34 is complete.

In a second example, the mount 33 for the substrate 34 may be articulated, that is, formed of at least two rods or other members that are connected to each other so that one can move relative to the other.

A specific example of this second example is shown schematically in Figures 3A and 3B. In this example, the mount 33 is formed of two mount portions 33a, 33b which are pivotally connected to each other at respective ends by a pivotable connection 35. The other end of the first mount potion 33a is mounted on or integrated with the body 31 of the substrate holder 30. In use, the substrate 34 is mounted on or otherwise carried by the other end of the second mount portion 33b. (It will be understood that there may be further, intermediate mount portions which are pivotally connected in other examples, so that the mount 33 is formed of a chain of pivotably connected mount portions.)

The pivotable connection 35 may be simply a flexible part, such as a relatively thin "living" hinge or the like, between the first and second mount portions 33a, 33b. In another example, the pivotable connection 35 may be a separate rigid hinge or the like. The mount portions 33a, 33b themselves may be rigid in this example. In this example, if a separate rigid hinge or the like is used for the pivotable connection 35, the first and second mount portions 33a, 33b and the pivotable connection 35 may be formed of a metal, such as a steel. This makes the first and second mount portions 33a, 33b and the pivotable connection 35 easier to clean to remove coated material after the deposition on the substrate 34 is complete, which helps to prevent blockage or seizing of the pivotable connection 35. Nevertheless, other materials, such as plastics such as for example polyamide or polypropylene, may be used for the first and second mount portions 33a, 33b in other examples.

The detailed arrangement of the mount 33 for the substrate 34 may be determined so that the throwing outwards of the substrate by centrifugal force can achieve the desired effects (for example, to better expose specific portions of the substrate 34 to the cloud of sputtering atoms that are liberated from the target in use). A number of factors and options are applicable for this purpose.

A first factor is the location of the centre of mass M of the substrate 34 relative to the connection point 36 of the substrate 34 to the mount 33. To illustrate this, in the example shown schematically in Figures 3A and 3B, the substrate 34 is mounted on the mount 33 so that the centre of mass M of the substrate 34 is lower than the connection point 36 of the substrate 34 to the mount 33. The effect of this is that as the rotational speed of the substrate holder 30 is increased so that the centre of mass M of the substrate 34 is thrown outwardly, the substrate 34 pivots upwards around the pivotable connection 35, so changing the orientation of the substrate 34 relative to the body 31. This could be reversed if desired, so that the centre of mass M of the substrate 34 is higher than the connection point 36 of the substrate 34 to the mount 33, leading to the substrate 34 pivots downwards around the pivotable connection 35 as the rotational speed is increased.

A second factor is in effect the rest position of the substrate 34 when the substrate holder 30 is not being rotated. For example, the arrangement may be such that in effect the or each substrate 34 is at a lowest position when the substrate holder 30 is not being rotated, and moves progressively upwards as the rotational speed of the substrate holder 30 is increased.

A first option is to provide a biasing member to support the weight of a substrate 34 mounted on the mount 33. This is indicated schematically by a biasing member 40 in the form of a coil spring 40 in Figures 3A and 3B (though the actual biasing member 40 used in practice does not need to be a coil spring as such, and other arrangements for the biasing member 40 are possible). The biasing member 40 in this example is arranged such that the substrate 34 is oriented at one orientation relative to the body 31 when the body 31 is rotating at a first rotational speed and cannot fall any further due to gravity but changes to a different orientation as the rotational speed is increased.

A second option is to provide a biasing member to control the throwing outward of a substrate 34 mounted on the mount 33 as the body 31 rotates in use. This is indicated schematically by a biasing member 40 in the form of a coil spring 40 in Figures 3A and 3B (though again the actual biasing member 40 used in practice does not need to be a coil spring as such, and other arrangements for the biasing member 40 are possible). In this example, this is the same biasing member 40 that supports the weight of the substrate 34 described above, though there may be separate biasing members 40 for these two functions in other examples, and only one biasing member that performs only one of these functions in yet other examples. In any event, in this example, as the rotational speed of the body 31 increases and the substrate 34 is thrown outwardly, the biasing member 40 controls how far out the substrate 34 is thrown at a certain rotational speed.

In summary, in examples described herein, the orientation of the substrate 34 relative to the body 31 will be different, depending on the rotational speed of the substrate 34 in the PVD chamber. This means in turn that different portions of the substrate 34 may be presented to the target (which is the source of the atoms used for the PVD coating) or, more generally, to the region where sputtered coating atoms are present, depending on the rotational speed. This can help ensure that no portions of the substrate 34 are blocked or occluded by other substrates 34 or other components in the PVD chamber, or at least reduces that amount of the substrate 34 that is blocked or occluded by other substrates 34 or other components in the PVD chamber. This can also reduce the processing time and reduce consumption of the target coating material, as more uniform coatings can be achieved more quickly and efficiently.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A substrate holder for holding a substrate during physical vapour deposition of a material on the substrate, the substrate holder comprising:
a body which is arranged to be rotatable in use during physical vapour deposition;
the body having a mount to which a substrate may be mounted in use during physical vapour deposition;
the mount being constructed and arranged such that as the body rotates in use, a substrate mounted on the mount is thrown outwardly by centrifugal force so as to change the orientation of the substrate relative to the body.

2. A substrate holder according to claim 1, wherein the mount comprises a first mount portion which is fixed to the body and a second mount portion to which a substrate may be mounted in use during physical vapour deposition, the first and second mount portions being pivotally connected to each other to allow a substrate mounted on the mount to be thrown outwardly by centrifugal force as the body rotates in use.

3. A substrate holder according to claim 1 or claim 2, wherein the mount is flexible.

4. A substrate holder according to any of claims 1 to 3, comprising a biasing member connected to the mount to support the weight of a substrate mounted on the mount.

5. A substrate according to any of claims 1 to 4, comprising a biasing member connected to the mount to control the throwing outward of a substrate mounted on the mount as the body rotates in use.

6. A substrate holder according to any of claims 1 to 5, wherein the substrate holder is a rotatable satellite substrate holder for mounting to a rotatable turntable of a physical vapour deposition apparatus.

7. A physical vapour deposition apparatus for holding a substrate during physical vapour deposition of a material on the substrate, the apparatus comprising:
a turntable which is rotatable about a first axis of rotation;
one or more substrate holders according to any of claims 1 to 6, wherein the or each substrate holder is mounted on the turntable to be rotatable about a second axis of rotation which is not coincident with the first axis of rotation.

8. Apparatus according to claim 7, comprising a motor for driving rotation of the turntable.

9. Apparatus according to claim 8, comprising a gear arrangement drivingly connecting the motor to the turntable and drivingly connecting the motor to the or each substrate holder.

10. A method of operating a physical vapour deposition apparatus for depositing a material on a substrate, the physical vapour deposition apparatus comprising a substrate holder comprising a rotatable body, the body having a mount to which a substrate is mounted, the method comprising
rotating the body at a first rotational speed; and
rotating the body at a second rotational speed which is greater than the first rotational speed to cause the substrate to be thrown outwardly by centrifugal force so as to change the orientation of the substrate relative to the body.

11. A method according to claim 10, wherein the mount comprises a first mount portion which is fixed to the body and a second mount portion to which a substrate may be mounted in use during physical vapour deposition, the first and second mount portions being pivotally connected to each other to allow a substrate mounted on the mount to be thrown outwardly by centrifugal force as the body rotates in use.

12. A method according to claim 10 or claim 11, wherein the substrate holder is a rotatable satellite substrate holder for mounting to a rotatable turntable of a physical vapour deposition apparatus.
